# EUROPEAN PATENT APPLICATION

(11) **EP 4 729 226 A1**
(43) Date of publication of application: **22.04.2026**
(21) Application number: 25207601.3
(22) Date of filing: 08.10.2025
(51) Int. Cl.: B23K 26/03, B23K 26/0622, B23K 26/082, B23K 26/38, B23K 31/12, H01M 4/04

(54) **LASER TEST DEVICE AND TEST METHOD FOR LASER SELECTION**

(30) Priority: 16.10.2024 KR 20240141471
(71) Applicant: SAMSUNG SDI CO., LTD., Yongin-si, Gyeonggi-do 17084 (KR)
(72) Inventor: CHOI, Kyuchul, 17084 Yongin-si (KR)
(74) Representative: Maiwald GmbH

(57) **Abstract**

A laser test device for a laser selection includes a roll-to-roll unit, a laser irradiation unit, and an inspection unit. The roll-to-roll unit includes a supply roller for unwinding a substrate sheet and a winding roller for rewinding the substrate sheet, and roll-to-roll unit transports the substrate sheet at a predetermined speed. The laser irradiation unit includes a laser oscillator, a scanner and an optical system, and irradiates a laser beam for notching the substrate sheet being transported to thereby form a plurality of extension tabs in the substrate sheet. The inspection unit is positioned at the rear of the laser irradiation unit and obtains a magnified image of the notched area of the substrate sheet being transported.

## Description

### BACKGROUND OF THE DISCLOSURE

### (a) Field of the Disclosure

The present disclosure relates to a laser test device for laser selection, and more particularly, to a laser test device and a laser test method for manufacturing an electrode of a rechargeable battery.

### (b) Description of the Related Art

Rechargeable batteries are used for a variety of purposes, including powering small electronic devices such as mobile phones and laptop computers, powering transportation devices such as electric vehicles and hybrid vehicles, and as energy storage devices in energy storage systems. The rechargeable battery basically includes an electrode assembly and a case that accommodates and seals the electrode assembly.

The electrode assembly includes two electrodes with different polarities and a separator that insulates the two electrodes. The electrode comprises a substrate and an active material layer, and the substrate includes an extension tab for bonding with an electrode terminal. The extension tab of the substrate may be manufactured by laser cutting. Laser cutting of the substrate requires optimizing a laser type, laser output, scan speed, etc. depending on the material and the thickness of the substrate.

### SUMMARY OF THE DISCLOSURE

The present disclosure provides a laser test device and a test method capable of testing laser cutting of a substrate by continuously changing a laser condition according to an actual process condition of cutting the substrate with a laser. The device and method facilitate the determination of an optimal laser condition suitable for the material and thickness of the substrate.

A laser test device according to an embodiment includes a roll-to-roll unit, a laser irradiation unit, and an inspection unit. The roll-to-roll unit includes a supply roller that unwinds the substrate sheet and a winding roller that rewinds the substrate sheet, and the roll-to-roll unit transports the substrate sheet at a predetermined speed. The laser irradiation unit includes a laser oscillator, a scanner, and an optical system, and the laser irradiation irradiates a laser beam for notching to the substrate sheet being transported to thereby form a plurality of extension tabs on the substrate sheet. The inspection unit is positioned after the laser irradiation unit in a direction that the roll-to-roll unit transports the substrate sheet and obtains a magnified image of a laser notching area in the substrate sheet being transported.

The laser test device may further include a tension control unit having a dancer roller that rotates in contact with the substrate sheet being transported. The tension control unit may control the tension applied to the substrate sheet to be the same as the tension applied to a substrate sheet when manufacturing an electrode of a rechargeable battery. The tension control unit may be positioned between the supply roller and the laser irradiation unit in the direction that the roll-to-roll unit transports the substrate sheet.

The roll-to-roll unit may further include a plurality of transport rollers for guiding the transport of the substrate sheet between the supply roller and the winding roller, and roll-to-roll unit may control the moving speed of the substrate sheet to be the same as a moving speed of a substrate sheet when manufacturing an electrode of a rechargeable battery.

The laser irradiation unit may be configured to vary at least one of an output, a pulse width, a pulse energy, and a pulse repetition rate of the laser beam during transport of the substrate sheet. The scanner may include a first galvanometer and a first mirror that scan the laser beam in X direction, and a second galvanometer and a second mirror that scan the laser beam in Y direction. The optical system may include an F-theta lens. The scanner and the optical system may be each configured to move in a Z direction.

The inspection unit may include an electron microscope and a display unit. The electron microscope may be positioned above a notched area of the substrate sheet to obtain a magnified image of the notched area as viewed from above. The electron microscope may be a first electron microscope, and the inspection unit may further include a second electron microscope. The second electron microscope may be positioned in front of the notched area in the direction that the roll-to-roll unit transports the substrate sheet, the second electron microscope being configured to obtain a magnified image of an incision surface of the substrate sheet as viewed from the front.

The laser test device may further include a chamber surrounding the laser irradiation unit, and an air blower and a suction nozzle positioned inside the chamber. The air blower may blow air toward an area where the substrate sheet is notched by the laser irradiation unit to blow away foreign substances and fumes. The suction nozzle may suction foreign substances and fumes scattered by the air blower.

According to another embodiment, a laser test device includes a roll-to-roll unit, a laser irradiation unit, a tension control unit, an inspection unit, and a control unit. The roll-to-roll unit includes a supply roller that unwinds the substrate sheet and a winding roller that rewinds the substrate sheet, and the roll-to-roll unit transports the substrate sheet at a predetermined speed. The laser irradiation unit includes a laser oscillator, a scanner, and an optical system, and irradiates a laser beam for notching substrate sheet being transported to thereby form a plurality of extension tabs on the substrate sheet. The tension control unit is positioned between the supply roller and the laser irradiation unit in the direction that the roll-to-roll unit transports the substrate sheet and is configured to control the tension of the substrate sheet being transported. The inspection unit is positioned at the rear of the laser irradiation unit in the direction that the roll-to-roll unit transports the substrate sheet and obtains a magnified image of a notched area in the substrate sheet being transported. The control unit controls the operation of the laser irradiation unit so that the laser irradiation unit changes at least one of an output, a pulse width, a pulse energy, and a pulse repetition rate of the laser beam while the substrate sheet is being transported.

The tension control unit may include a dancer roller that rotates in contact with the substrate sheet, and the tension control unit may control the tension of the substrate sheet to be the same as the tension applied to a substrate sheet during manufacturing of an electrode of a rechargeable battery. The roll-to-roll unit may further include a plurality of transport rollers for guiding the transport of the substrate sheet between the supply roller and the winding roller. The roll-to-roll unit may control the moving speed of the substrate sheet to be the same as a moving speed of the substrate sheet when manufacturing an electrode of a rechargeable battery.

The inspection unit may include an electron microscope and a display unit. The electron microscope may be positioned above the notched area of the substrate sheet to obtain a magnified image of the notched area viewed from above. The electron microscope may be a first electron microscope, and the inspection unit may further include a second electron microscope. The second electron microscope may be positioned in front of the notched area in the direction that the roll-to-roll unit transports the substrate sheet to obtain a second magnified image of an incision surface of the substrate sheet as viewed from the front.

A laser test method according to an embodiment includes transporting a substrate sheet at a predetermined speed while controlling tension on the substrate sheet; forming a plurality of extension tabs on the substrate sheet by irradiating a laser beam to notch the substrate sheet being transported; and obtaining a magnified image of a notched area of the substrate sheet being transported.

The substrate sheet may be transported by a roll-to-roll unit and the tension on the substrate sheet may be controlled by a tension control unit equipped with a dancer roller. In the transport step, the moving speed of the substrate sheet being transported may be controlled to be the same as a moving speed of the substrate sheet when manufacturing an electrode of a rechargeable battery, and the tension applied to the substrate sheet may be controlled to be the same as tension applied to the substrate sheet when manufacturing the electrode of the rechargeable battery.

The laser beam may be provided by a laser irradiation unit including a laser oscillator, a scanner, and an optical system. The laser irradiation unit may vary at least one of an output, a pulse width, a pulse energy, and a pulse repetition rate of the laser beam during transport of the substrate sheet.

The magnified image may be obtained an inspection unit including an electron microscope and a display unit. The electron microscope may be positioned above the notched area of the substrate sheet to provide the magnified image o as viewed from above. The electron microscope may be a first electron microscope and the magnified image is a first magnified image, and the inspection unit may further include a second electron microscope positioned in front of the area where the substrate sheet is notched. The second electron microscope may provide a second magnified image of the incision surface of the substrate sheet as viewed from the front.

According to embodiments, the optimal laser condition may be selected according to the thickness and material of the substrate sheet, and the selected laser condition may be replicated in the actual manufacturing process of the rechargeable battery. Additionally, a large amount of the testing for the laser selection may be efficiently performed in a short period of time.

### BRIEF DESCRIPTION OF THE DRAWINGS

FIG. 1 is a schematic diagram of a laser test device according to an embodiment.
FIG. 2 is a schematic diagram showing a portion of a roll-to-roll unit and a substrate sheet of the laser test device shown in FIG. 1.
FIG. 3 is a schematic diagram showing an alternative to embodiment illustrated in FIG. 2.
FIG. 4 is a cross-sectional view taken along a line A-A of FIG. 3.
FIG. 5 is a view showing an example of the laser irradiation unit shown in FIG. 1.
FIG. 6 is a schematic diagram showing a processing process of forming an extension tab of the substrate sheet shown in FIG. 2.
FIG. 7 is a schematic diagram showing a processing process of forming an extension tab of the substrate sheet shown in FIG. 3.
FIG. 8 is a schematic perspective view of a substrate sheet and the electron microscope shown in FIG. 1.
FIG. 9 is a schematic diagram showing a modified embodiment of an inspection unit illustrated in FIG. 1 and FIG. 8.
FIG. 10 is a flowchart showing a laser test method using the laser test device shown in FIG. 1.

### DETAILED DESCRIPTION OF THE EMBODIMENTS

The present disclosure will be described more fully hereinafter with reference to the accompanying drawings, in which embodiments of the disclosure are shown. As those skilled in the art would realize, the described embodiments may be modified in various different ways without departing from the scope of the present disclosure.

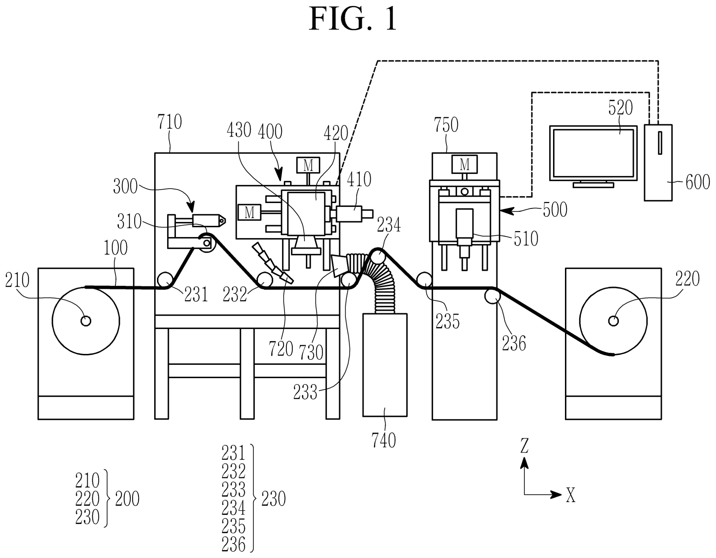

FIG. 1 is a schematic diagram of a laser test device according to an embodiment.

Referring to FIG. 1, the laser test device according to the present embodiment may include a roll-to-roll unit 200 for transporting a substrate sheet 100, a tension control unit 300 for controlling tension of the substrate sheet 100 being transported, a laser irradiation unit 400 for irradiating the substrate sheet 100 being transported with a laser beam to perform laser cutting (notching), and an inspection unit 500 for obtaining a magnified image of a laser notching portion. The laser test device may further include a control unit 600 that controls the operation of the laser irradiation unit 400 and the inspection unit 500.

The substrate sheet 100 is transported under tension. During the transport process, the substrate sheet 100 passes sequentially through one side space (e.g., a lower space) of the laser irradiation unit 400 and one side space (e.g., a lower space) of the inspection unit 500. Laser notching and notching area inspection are thereby performed continuously on the substrate sheet 100 to which the tension is applied.

The substrate sheet 100 is identical the same as a substrate sheet for manufacturing an electrode of a rechargeable battery. The roll-to-roll unit 200 may transport the substrate sheet 100 at the same speed as the moving speed of the same type of substrate sheet when actually manufacturing an electrode of a rechargeable battery. The tension control unit 300 may apply the same tension to the substrate sheet 100 as the tension applied to the substrate sheet during the actual manufacture of an electrode of a rechargeable battery.

The laser test device may perform laser notching while changing the conditions of the laser under the same or similar conditions as in actual manufacturing processes of electrodes of the rechargeable batteries. Also, the laser test device may perform various laser notching tests by inspecting the notching area by using the inspection unit 500 immediately after the notching. Using this laser test device, it is easy to select optimized laser process conditions suitable for the material and thickness of the substrate sheet 100.

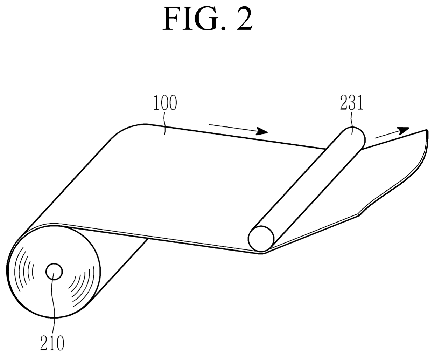

FIG. 2 is a schematic diagram showing a portion of a roll-to-roll unit and a substrate sheet of the laser test device shown in FIG. 1.

Referring to FIG. 1 and FIG. 2, the substrate sheet 100 may be have a thin thickness, a constant width, and a length that is longer than its width. The substrate sheet 100 may be bent and wound on a roller. The substrate sheet 100 may be composed of a thin metal plate with excellent electrical conductivity.

For example, the substrate sheet 100 may be composed of an aluminum foil, an aluminum mesh, a copper foil, a copper mesh, a nickel foil, or a nickel mesh. The aluminum foil and the aluminum mesh may be used as a positive electrode substrate for the rechargeable battery. The copper foil, the copper mesh, the nickel foil, and the nickel mesh may be used as a negative electrode substrate for the rechargeable battery.

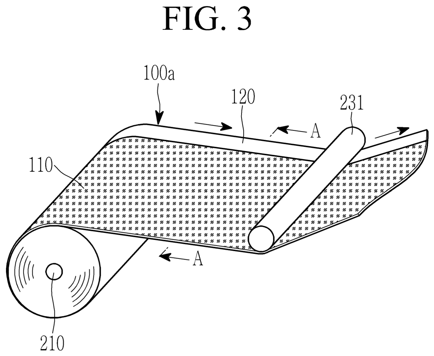

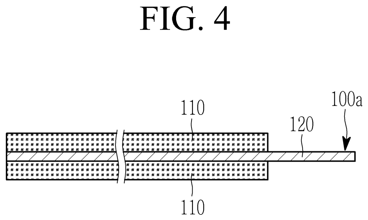

FIG. 3 is a schematic diagram showing a modified embodiment of the substrate sheet illustrated in FIG. 2. FIG. 4 is a cross-sectional view taken along line A-A of FIG. 3.

Referring to FIG. 3 and FIG. 4, an active material layer 110 may be positioned on at least one surface of a substrate sheet 100a. FIG. 4 illustrates a case where the active material layer 110 is positioned on both surfaces of the substrate sheet 100a. The active material layer 110 may include an active material and may further optionally include a binder and/or a conductive material. A positive active material layer includes a positive active material and a negative active material layer includes a negative active material.

The positive active material may include a lithium transition metal composite oxide. The lithium transition metal composite oxide may include, for example, at least one of a lithium-nickel oxide, a lithium-cobalt oxide, a lithium-manganese oxide, a lithium-phosphoric acid iron compound, and a cobalt-free lithium nickel-manganese oxide. The negative active material may include at least one of a carbon-based active material and a silicon-based active material. The carbon-based active material may include at least one of a natural graphite and an artificial graphite. The silicon-based active material may include at least one of a silicon-carbon composite active material, silicon oxide (SiOx, where 0<x≤2), and silicon carbide.

The active material layer 110 may be made in processes wherein an active material slurry is applied a substrate, and the slurry is dried and compressed. The active material layer 110 may be positioned in any area of the substrate sheet 100a except for one edge. That is, the substrate sheet 100a may include an edge portion that is not covered by the active material layer 110, which may be referred to as an uncoated area 120.

Referring to FIG. 1 and FIG. 2, the roll-to-roll unit 200 may include a supply roller 210, a winding roller 220, and a plurality of transport rollers 230. The supply roller 210 may be referred to as an unwinder, and the winding roller 220 may be referred to as a rewinder.

The supply roller 210 and the winding roller 220 may be positioned at opposite ends of the laser test device. The plurality of transport rollers 230 may be positioned between the supply roller 210 and the winding roller 220 to guide the transport of the substrate sheet 100 through the laser test device. That is, the tension control unit 300, the laser irradiation unit 400, and the inspection unit 500 may be positioned between the supply roller 210 and the winding roller 220.

The supply roller 210 may wind and store the substrate sheet 100, and the supply roller 210 may unwind the substrate sheet 100 by rotating in one direction. The winding roller 220 may rewind the substrate sheet 100 after laser notching and inspection of the notching area are completed. Each of the supply roller 210, the winding roller 220, and the plurality of transport rollers 230 may be rotated by a driving means such as a motor (not shown).

The plurality of transport rollers 230 may be positioned at a predetermined positions along the length direction (transport direction) of the substrate sheet 100, and at least two transport rollers 230 may be positioned at different heights (Z direction shown in FIG. 1). The plurality of transport rollers 230 may be in contact with the substrate sheet 100 to maintain the tension of the substrate sheet 100 and change the movement path of the substrate sheet 100. Although six transport rollers 230 are shown in the drawings, the number and position of the transport rollers 230 are not limited to the illustrated example.

The tension control unit 300 may be positioned between the supply roller 210 and the laser irradiation unit 400. The tension control unit 300 may include a dancer roller 310, a sensor, and a feedback control unit. The dancer roller 310 may be positioned between a first transport roller 231 and a second transport roller 232, and the dancer roller 310 may be positioned higher than the first and second transport rollers 231 and 232. The substrate sheet 100 moves by the dancer roller 310.

The dancer roller 310 may move up-and-down following the flow of the substrate sheet 100. For example, when the tension increases, the dancer roll 310 may descend, and when the tension decreases, the dancer roll 310 may ascend. The sensor may detect changes in the tension according to the up-and-down motion of the dancer roll 310 and transmit a detection signal to the feedback control unit.

The feedback control unit may analyze the detection signal and execute a control algorithm to maintain the tension of the substrate sheet 100. In particular, the feedback control unit may control the tension of the substrate sheet 100 by adjusting the position and speed of the dancer roll 310 using a control algorithm, and the dancer roller 310 may maintain the tension of the substrate sheet 100 at a target level.

The tension control unit 300 may be positioned in front of the laser irradiation unit 400 so that the tension of the substrate sheet 100 may be precisely controlled just before laser notching occurs. That is, the optimal position of the tension control unit 300 may be between the supply roller 210 and the laser irradiation unit 400, and the tension of the substrate sheet 100 moving toward the laser irradiation unit 400 may be consistently maintained at the target level to enable performance of an accurate laser test.

The laser irradiation unit 400 may include a laser oscillator 410, a scanner 420, and an optical system 430. The control unit 600 may be electrically connected to the laser irradiation unit 400 to control the operation of the laser irradiation unit 400. The control unit 600 may be configured as a computer device.

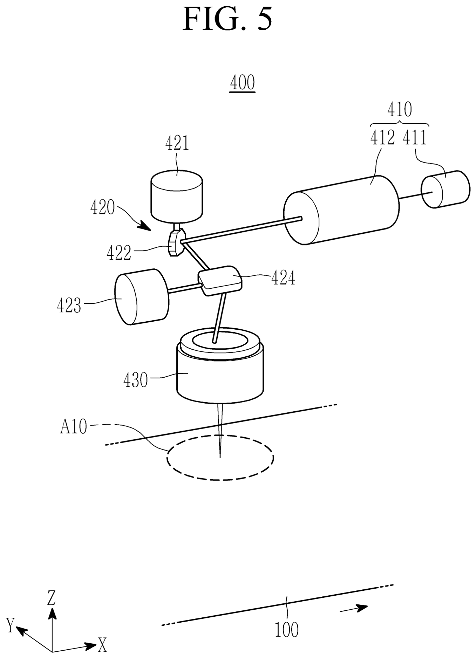

FIG. 5 is an example of the laser irradiation unit shown in FIG. 1.

Referring to FIG. 1 and FIG. 5, the laser irradiation unit 400 may include a laser oscillator 410 for emitting a laser beam, a scanner 420 for moving the laser beam in the X direction and the Y direction, and an optical system 430 for adjusting the focus of the laser beam. Here, the X direction is parallel to the length direction (transport direction) of the substrate sheet 100, and the Y direction is parallel to the width direction of the substrate sheet 100.

The laser oscillator 410 may include a laser light source 411 and a beam expander 412 and may emit a laser beam for cutting (notching) the substrate sheet 100. The laser oscillator 410 may emit pulse lasers with an output of approximately 10 W to 1,000 W and may have a configuration that continuously changes the conditions of the laser beam. For example, the laser oscillator 410 may continuously vary at least one of the output, the pulse width, the pulse energy, and the pulse repetition rate of the laser beam.

For example, the laser oscillator 410 may adjust the output of the laser beam within a range of 10 W to 1,000 W and may modulate the pulse width (pulse duration) of the laser beam within a range of 30 ns to 240 ns. Additionally, the laser oscillator 410 may adjust the pulse energy within a range of greater than 0 and less than or equal to 2 mJ and the pulse repetition rate within a range of 100 kHz to 4,000 kHz.

The scanner 420 may be configured, for example, as a galvanometer scanner. The scanner 420 may include, for example, a first galvanometer 421, a first mirror 422 coupled to the first galvanometer 421, a second galvanometer 423, and a second mirror 424 coupled to the second galvanometer 423. The laser beam may be reflected from the first mirror 422 to the second mirror 424. The laser beam may be reflected from the second mirror 424 to the optical system 430.

The first galvanometer 421 may be rotated by a first motor, and the first mirror 422 may be moved to scan the laser beam in the X direction. The second galvanometer 423 may be rotated by a second motor, and the second mirror 424 may be moved to scan the laser beam in the Y direction. Thus, the laser beam is scanned by the micro-motion of the first mirror 422 and the second mirror 424.

The optical system 430 may include a plurality of lenses, for example, an F-theta lens. A F-theta lens is a scan lens specially designed to focus a laser beam incident from various directions onto a plane, and a F-theta lens may implement a nearly constant spot size within an investigation region (scan field) A10 regardless of the incident direction of the laser beam.

The entire scanner 420 may move in the Z direction, and the focus of the scanner 420 may be adjusted by moving in the Z direction. The optical system 430 may also move in the Z direction, and the focus of the optical system 430 may be adjusted by moving in the Z direction. The Z direction may be a direction orthogonal to the X direction and the Y direction, and Z direction may be parallel to the thickness direction of the substrate sheet 100 passing through the lower space of the laser irradiation unit 400 (as shown in FIG. 5).

The configuration of the scanner 420 and the optical system 430 is not limited to the examples described above and various alternatives are possible.

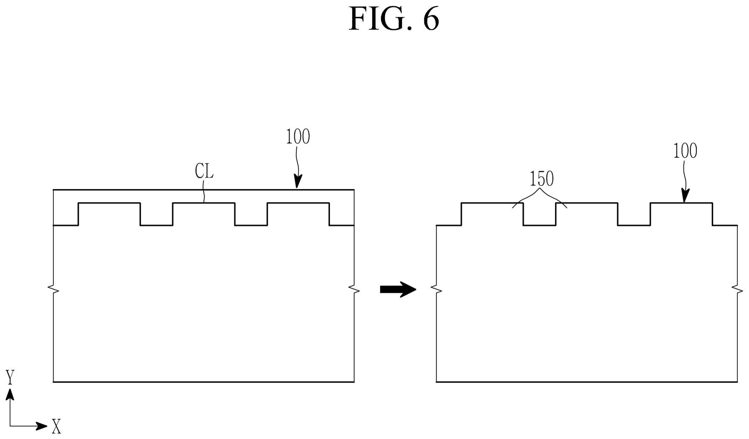

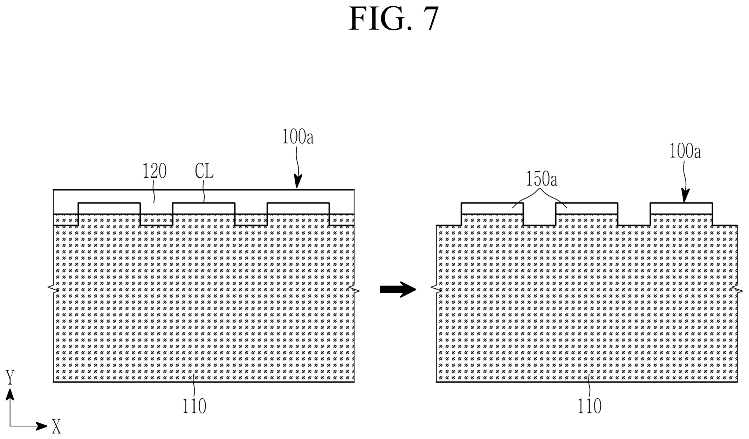

The substrate sheet 100 is cut (notched) by the laser beam while passing through the lower space of the laser irradiation unit 400, and a plurality of extension tabs may be formed in the substrate sheet 100. FIG. 6 is a schematic diagram showing a processing notching of an extension tab in the substrate sheet shown in FIG. 2. FIG. 7 is a schematic diagram showing a processing notching of an extension tab in the substrate sheet shown in FIG. 3.

Referring to FIG. 6 and FIG. 7, a laser beam may be irradiated on substrate sheets 100 and 100a to cut the substrate sheets 100 and 100a. By transporting the substrate sheets 100 and 100a and scanning the laser beam, a plurality of extension tabs 150 and 150a may be continuously created at a distance from each other. In FIG. 6 and FIG. 7, CL represents a cutting line by the laser beam.

The plurality of extension tabs 150 and 150a may be roughly a quadrangle and be the same size. In the case of FIG. 7, the laser beam may alternately cut a region covered with the active material layer 110 of the substrate sheet 100a and a region not covered with the active material layer 110, i.e., the uncoated area 120. In this case, the active material layer 110 may be positioned on a part of the extension tab 150a.

If the extension tab of the rechargeable battery electrode to be actually manufactured does not come into contact with the active material layer, the substrate sheet 100 illustrated in FIG. 6 may be used. On the other hand, if the active material layer is positioned on a part of the extension tab of the rechargeable battery electrode to be actually manufactured, the substrate sheet 100a illustrated in FIG. 7 may be used.

The scan speed of the laser beam may be faster than the moving speed of the substrate sheets 100 and 100a. The plurality of extension tabs 150 and 150a may be processed by scanning the laser beam on the substrate sheets 100 and 100a one time. Alternatively, the plurality of extension tabs 150 and 150a may be processed by scanning the laser beam on the substrate sheets 100 and 100a two or more times. That is, laser notching may be performed by irradiating the same area of the substrate sheets 100 and 100a with the laser beam two or more times.

Referring again to FIG. 1, the laser test device may further include a first chamber 710 surrounding a laser irradiation unit 400, and an air blower 720 and a suction nozzle 730 positioned within the first chamber 710. The first chamber 710 may be configured to surround the laser irradiation unit 400 or to surround both the tension control unit 300 and the laser irradiation unit 400. FIG. 1 illustrates the latter case as an example.

During the process of the laser beam cutting the substrate sheet 100, foreign substances and fumes may be generated from the substrate sheet 100. The fumes are vapor or dust generated during the cutting of the substrate sheet of the metal using heat, and the fumes may include a large amount of particulate matter that is harmful to the human body. The first chamber 710 has a sealed structure except for the inlet through which the substrate sheet 100 enters and the outlet through which the substrate sheet 100 exits, thereby preventing the foreign substances and fumes generated during the laser cutting from spreading to the external environment.

The air blower 720 blows air toward the irradiation region of the laser beam to blow away the foreign substances and fumes generated during the laser cutting. The suction nozzle 730 may be positioned to face the air blower 720 with the irradiation region of the laser beam therebetween. The suction nozzle 730 may suction the foreign substances and fumes scattered by the air blower 720. But the installation positions of the air blower 720 and the suction nozzle 730 are not limited to the example shown in FIG. 1.

If the foreign substances and fumes remain in the laser irradiation area, they may cause interference with the laser beam, causing the laser cutting quality to deteriorate. The air blower 720 and the suction nozzle 730 may improve the laser cutting quality by preventing the foreign substances and fumes from remaining in the laser irradiation area.

The suction nozzle 730 may be connected to a dust collector 740 by a piping. The dust collector 740 may be positioned outside the first chamber 710 and may include a vacuum pump and a filter. The suction nozzle 730 may suction the foreign substances and fumes by the pressure from the vacuum pump, and the air suctioned together with the foreign substances and fumes may be purified by the filter and then discharged to outside of the dust collector 740.

The inspection unit 500 may be positioned at the rear of the laser irradiation unit 400, and the substrate sheet 100 having the plurality of extension tabs formed therein may pass through the lower space of the inspection unit 500. Third to fifth transport rollers 233, 234, and 235 may be positioned between the laser irradiation unit 400 and the inspection unit 500. The substrate sheet 100 may be maintained at a constant tension by the third to fifth transport rollers 233, 234, and 235.

The inspection unit 500 may obtain a magnified image of the laser notching area and may provide information about the cutting status of the laser notching area to the user. The inspection unit 500 may include an electron microscope 510 and a display unit 520. The control unit 600 may be electrically connected to the electron microscope 510 to control the operation of the electron microscope 510 and may store the images obtained by the electron microscope 510.

The electron microscope 510 may be positioned above the laser notching area and may generate the magnified image viewed from above the laser notching area. The electron microscope 510 may be positioned inside a second chamber 750, and the display unit 520 may be positioned outside the second chamber 750.

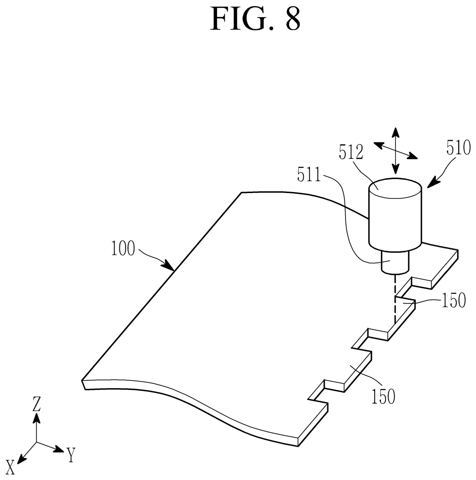

FIG. 8 is a schematic perspective view of a substrate sheet and an electron microscope as shown in FIG. 1.

Referring to FIG. 1 and FIG. 8, the electron microscope 510 may include a light source, a microscope optical system 511, and an optical system stage 512. The light source may irradiate light to the laser cutting area of the substrate sheet 100. The microscope optical system 511 may include an imaging element and a plurality of lenses and may produce a magnified image of the laser notching area.

The optical system stage 512 may include a Z direction driver and a Y direction driver coupled to the microscope optical system 511. The Z direction driver may move the microscope optical system 511 in the Z direction to adjust the focus. The Y direction driver may move the microscope optical system 511 in the Y direction to move the inspection area. The display unit 520 may display the magnified image obtained by the electron microscope 510.

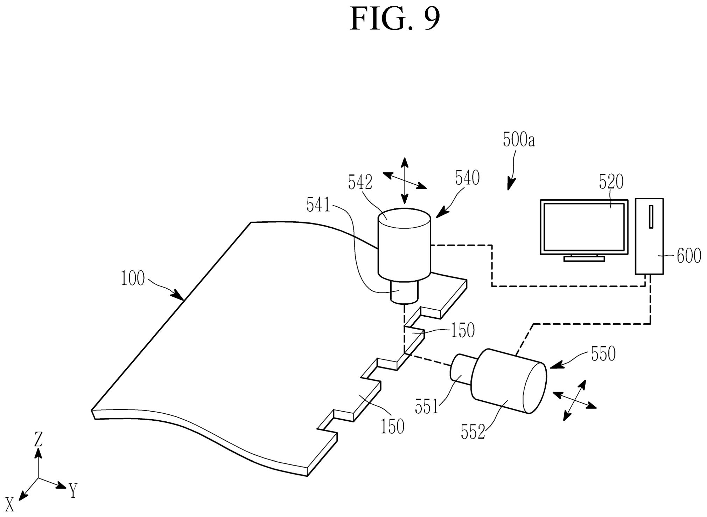

FIG. 9 is a schematic diagram showing another embodiment of the inspection unit illustrated in FIG. 1 and FIG. 8.

Referring to FIG. 9, the inspection unit 500a may include a first electron microscope 540 and a second electron microscope 550 provided at different positions to be directed in different observation directions. The control unit 600 may be electrically connected to the first electron microscope 540 and the second electron microscope 550. The first electron microscope 540 and the second electron microscope 550 may each include a light source, microscope optical systems 541 and 551, and optical system stages 542 and 552.

The first electron microscope 540 may be positioned above the laser notching area and may obtain the magnified image of the laser notching area viewed from above. The second electron microscope 550 may be positioned in front of the laser notching area and may obtain the magnified image of the incision surface of the substrate sheet 100 caused by the laser notching as viewed from the front. That is, the second electron microscope 550 may obtain the magnified image of the incision surface.

The optical system stage 542 of the first electron microscope 540 may include a Z direction driver for focus adjustment and a Y direction driver for moving the inspection area. The optical system stage 552 of the second electron microscope 550 may include a Y direction driver for focus adjustment and an X direction driver for moving the inspection area. The configuration of the optical system stages 542 and 552 is not limited to the examples described above and depicted in the figures, and various alternatives are possible.

The inspection unit 500a may provide more information to the user about the cutting status of the laser notching portion by using the first and second electron microscopes 540, and 550 as compared to the inspection unit 500 described above. For example, the inspection unit 500a may provide information on the roughness of the cutting line, the roughness of the incision surface, the degree of deformation of the substrate sheet, and the detailed shape of the incision surface.

Referring again to FIG. 1, the substrate sheet 100 having passed through the lower space of the inspection unit 500 may be wound onto the winding roller 220 via a sixth transport roller 236.

A user may analyze the information provided by the inspection unit 500 to select the optimal laser condition for the thickness and material of the substrate sheet 100. For example, it is possible to select the optimal laser condition minimizes the roughness of the cutting line, the roughness of the incision surface, and/or the degree of deformation of the substrate sheet 100.

A typical laser notching area inspection is performed by preparing a substrate cut into an individual unit, cutting the substrate with a laser beam, then moving the substrate to a location where an electron microscope is located and inspecting the notching area with the electron microscope. With this type of testing method, it is difficult to efficiently conduct a large amount of testing in a short period of time. In addition, since the substrate of the individual unit is in a tension-free state in the typical inspection method, if the laser process condition tested on the substrate of the individual unit is applied to the actual manufacturing process of the rechargeable battery, a cutting result may be different from the result tested on the substrate of the individual unit. In other words, the optimal laser condition selected for the substrate of the individual unit may not be the optimal laser condition in the actual manufacturing process of the rechargeable battery.

In the laser test device of the present embodiment, the substrate sheet 100 is transported under tension, and the laser notching and the inspection of the notching area are continuously performed. Since this configuration tests the laser condition on the substrate sheet 100 under the same conditions as the actual manufacturing process of the electrode of rechargeable battery, the optimal laser condition selected using the laser test device of the present disclosure may be equally applied to the actual manufacturing process of the rechargeable battery.

In addition, according to the laser test device of the present disclosure, the laser condition may be changed by controlling the operation of the laser irradiation unit 400 during the transport of the substrate sheet 100, and the laser notching area may be inspected in real time by using the inspection unit 500 immediately after the laser condition is changed. Thus, a large amount of testing may be efficiently performed in a short period of time.

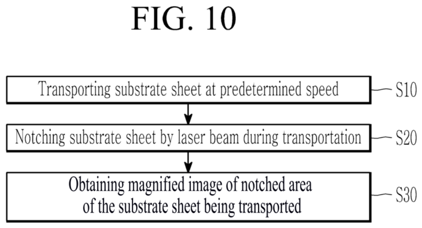

FIG. 10 is a flowchart of a laser test method using the laser test device shown in FIG. 1.

Referring to FIG. 10, the laser test method according to the present embodiment may include a transport step S10 of transporting a substrate sheet under tension at a predetermined speed, a notching step S20 of irradiating the substrate sheet with a laser beam during the transport of the substrate sheet to thereby notch the substrate sheet, and an inspection step S30 of obtaining a magnified image of the laser notching area during the transport of the substrate sheet.

Referring to FIG. 1 to FIG. 10, the roll-to-roll unit 200 and the tension control unit 300 may be used in the transport step S10, and the laser irradiation unit 400 may be used in the notching step S20. The inspection unit 500 including the electron microscope 510 may be used in the inspection step S30. The notching step S20 and the inspection step S30 may be performed sequentially with a time between the steps being equal to the time it takes for the substrate sheet 100 to move from the lower space of the laser irradiation unit 400 to the lower space of the inspection unit 500.

In the transport step S10, the substrate sheet 100 may be unwound from the supply roller 210, may pass through a plurality of transport rollers 230, and may be then wound again on the winding roller 220. The tension control unit 300 may be positioned between the supply roller 210 and the laser irradiation unit 400, and the substrate sheet 100 may be consistently maintained at a target level of tension by the tension control unit 300. The tension control unit 300 may be, for example, a dancer roller type, but the present disclosure is not limited to this example.

The substrate sheet 100 may be, for example, any one of aluminum foil, aluminum mesh, copper foil, copper mesh, nickel foil, and nickel mesh. The active material layer 110 may be positioned on at least one surface of the substrate sheet 100a, and the uncoated area 120 may be positioned along the edge of the substrate sheet 100a.

When the substrate sheet 100a is aluminum foil or aluminum mesh, the positive active material layer may be positioned on at least one surface of the substrate sheet. When the substrate sheet 100a is any one of copper foil, copper mesh, nickel foil, and nickel mesh, the negative active material layer may be positioned on at least one surface of the substrate sheet.

The moving speed of the substrate sheet 100 in the transport step S10 may be the same as the moving speed of the substrate sheet when actually manufacturing the electrode of the rechargeable battery. The tension of the substrate sheet 100 in the transport step S10 may be the same as the tension applied to the substrate sheet during the actual manufacture of the electrode of the rechargeable battery.

In the notching step S20, the laser irradiation unit 400 may scan the laser beam toward the substrate sheet 100 to cut (notch) the substrate sheet 100 and thereby form the plurality of extension tabs 150. The plurality of extension tabs 150 may be formed consecutively and spaced apart from each other. When the active material layer 110 is positioned on the substrate sheet 100a, the laser beam may alternately cut the area covered by the active material layer 110 and the uncoated area 120 of the substrate sheet 100a.

The laser irradiation unit 400 may include the laser oscillator 410, the scanner 420, and the optical system 430. The laser oscillator 410 may vary at least one of the output, pulse width, pulse energy, and pulse repetition rate of the laser beam. Since the scan speed of the laser beam is faster than the moving speed of the substrate sheet 100, the plurality of extension tabs 150 may be formed by repeatedly scanning the laser beam on the substrate sheet 100 two or more times.

When the laser condition changes in the notching step S20, the cutting degree of the substrate sheet 100, the roughness of the cutting line, the roughness of the incision surface, and the degree of deformation of the substrate sheet 100 also change. The laser irradiation unit 400 may be positioned inside the first chamber 710 along with the air blower 720 and the suction nozzle 730. The air blower 720 and the suction nozzle 730 may improve the laser cutting quality removing foreign matter and fumes from the laser irradiation area.

In the inspection step S30, the inspection unit 500 may obtain and store the magnified image of the laser notching area and may provide information to a user on the cutting status of the laser notching area. The inspection unit 500 may include at least one electron microscope. The electron microscope 510 may be positioned above the laser notching area. In another example, the first electron microscope 540 may be positioned above the laser notching area, and the second electron microscope 550 may be positioned in front of the laser notching area.

The first electron microscope 540 may obtain the magnified image of the laser notching area from above. The second electron microscope 550 may obtain the magnified image of the incision surface as viewed from the front. The inspection unit 500 may provide information on the roughness of the cutting line, the roughness of the incision surface, the degree of deformation of the substrate sheet, and the detailed shape of the incision surface.

A user may change the laser condition by controlling the laser irradiation unit 400 during the transport of the substrate sheet 100, and a user may inspect the laser notching area by using the inspection unit 500 immediately after changing the laser condition. According to the above-described method, a large amount of testing may be efficiently conducted in a short period of time, and the optimal laser condition may be easily selected for the thickness and material of the substrate sheet 100.

## Claims

1. A laser test device comprising:
a roll-to-roll unit (200) including a supply roller (210) for unwinding a substrate sheet (100, 100a) and a winding roller (220) for rewinding the substrate sheet (100, 100a), the roll-to-roll unit (200) being configured to transport the substrate sheet (100, 100a) at a predetermined speed;
a laser irradiation unit (400) including a laser oscillator (410), a scanner (420), and an optical system, and the laser irradiation unit (400) being configured to irradiate a laser beam for notching the substrate sheet (100, 100a) being transported to thereby form a plurality of extension tabs (150, 150a) in the substrate sheet (100, 100a); and
an inspection unit (500, 500a) positioned after the laser irradiation unit (400) in a direction that the roll-to-roll unit (200) transports the substrate sheet (100, 100a), the inspection unit (500, 500a) being configured to obtain a magnified image of a laser notching area in the substrate sheet (100, 100a) being transported.

2. The laser test device of claim 1, further comprising:
a tension control unit (300) having a dancer roller (310) configured to rotate in contact with the substrate sheet (100, 100a) being transported, and
the tension control unit (300) configured to control tension applied to the substrate sheet (100, 100a) to be the same as tension applied to a substrate sheet (100, 100a) when manufacturing an electrode of a rechargeable battery.

3. The laser test device of claim 2, wherein the tension control unit (300) is positioned between the supply roller (210) and the laser irradiation unit (400) in the direction that the roll-to-roll unit (200) transports the substrate sheet (100, 100a).

4. The laser test device of any one of the claims 1 to 3, wherein the roll-to-roll unit (200) further includes a plurality of transport rollers (230-234) for guiding the transport of the substrate sheet (100, 100a) between the supply roller (210) and the winding roller (220), and the roll-to-roll unit (200) is configured to control a moving speed of the substrate sheet (100, 100a) to be the same as a moving speed of a substrate sheet (100, 100a) when manufacturing an electrode of a rechargeable battery.

5. The laser test device of any one of the claims 1 to 4, wherein the laser irradiation unit (400) is configured to vary at least one of an output, a pulse width, a pulse energy, and a pulse repetition rate of the laser beam during transport of the substrate sheet (100, 100a).

6. The laser test device of claim 5, wherein the scanner (420) includes a first galvanometer (421) and a first mirror (422) that are configured to scan the laser beam in an X direction, and a second galvanometer (423) and a second mirror (424) that are configured to scan the laser beam in a Y direction,
wherein the optical system includes an F-theta lens, and
wherein the scanner (420) and the optical system are each configured to move in a Z direction.

7. The laser test device of any one of the claims 1 to 6, wherein the inspection unit (500, 500a) includes an electron microscope (510, 540) and a display unit (520), and
wherein the electron microscope (510, 540) is positioned above a notched area of the substrate sheet (100, 100a) to obtain a magnified image of the notched area as viewed from above.

8. The laser test device of claim 7, wherein the electron microscope (510, 540) is a first electron microscope (540) and the magnified image is a first magnified image, and
wherein the inspection unit (500, 500a) further includes a second electron microscope (550) positioned in front of the notched area in the direction that the roll-to-roll unit (200) transports the substrate sheet (100, 100a), the second electron microscope (550) being configured to obtain a second magnified image of an incision surface of the substrate sheet (100, 100a) as viewed from the front.

9. The laser test device of any one of the claims 1 to 8, further comprising:
a chamber (710, 750) surrounding the laser irradiation unit (400);
an air blower (720) positioned inside the chamber (710, 750) and configured to blow air toward an area (120) where the substrate sheet (100, 100a) is notched by the laser irradiation unit (400) to blow away foreign substances and fumes; and
a suction nozzle (730) positioned inside the chamber (710, 750) and configured to suction foreign substances and fumes scattered by the air blower (720).

10. A laser test device comprising:
a roll-to-roll unit (200) including a supply roller (210) configured to unwind a substrate sheet (100, 100a) and a winding roller (220) configured to rewind the substrate sheet (100, 100a), the roll-to-roll unit (200) being configured to transport the substrate sheet (100, 100a) at a predetermined speed;
a laser irradiation unit (400) including a laser oscillator (410), a scanner (420), and an optical system, the laser irradiation unit (400) being configured to irradiate a laser beam for notching the substrate sheet (100, 100a) being transported to thereby form a plurality of extension tabs (150, 150a) in the substrate sheet (100, 100a);
a tension control unit (300) positioned between the supply roller (210) and the laser irradiation unit (400) in the direction that the roll-to-roll unit (200) transports the substrate sheet (100, 100a), the tension control unit (300) being configured to control the tension of the substrate sheet (100, 100a) being transported;
an inspection unit (500, 500a) positioned at the rear of the laser irradiation unit (400) in the direction that the roll-to-roll unit (200) transports the substrate sheet (100, 100a), the inspection unit (500, 500a) being configured to obtain a magnified image of a notched area of the substrate sheet (100, 100a) being transported; and
a control unit (600) configured to control operation of the laser irradiation unit (400) so that the laser irradiation unit (400) changes at least one of an output, a pulse width, a pulse energy, and a pulse repetition rate of the laser beam while the substrate sheet (100, 100a) is being transported.

11. A laser test method comprising:
transporting a substrate sheet (100, 100a) at a predetermined speed while controlling tension on the substrate sheet (100, 100a);
forming a plurality of extension tabs (150, 150a) on the substrate sheet (100, 100a) by irradiating the laser beam to notch the substrate sheet (100, 100a) being transported; and
obtaining a magnified image of a notched area of the substrate sheet (100, 100a) being transported.

12. The laser test method of claim 11, wherein the substrate sheet (100, 100a) is transported by a roll-to-roll unit (200) and a tension on the substrate sheet (100, 100a) is controlled by a tension control unit (300) that includes a dancer roller (310).

13. The laser test method of claim 12, wherein the moving speed of the substrate sheet (100, 100a) being transported is controlled to be the same as a moving speed of a substrate sheet (100, 100a) when manufacturing an electrode of a rechargeable battery, and the tension applied to the substrate sheet (100, 100a) is controlled to be the same as a tension applied to a substrate sheet (100, 100a) when manufacturing an electrode of a rechargeable battery.

14. The laser test method of any one of the claims 11 to 13, wherein the laser beam is provided a laser irradiation unit (400) that includes a laser oscillator (410), a scanner (420), and an optical system, and
wherein the laser irradiation unit (400) varies at least one of an output, a pulse width, a pulse energy, and a pulse repetition rate of the laser beam during transport of the substrate sheet (100, 100a).

15. The laser test method of any one of the claims 11 to 14, wherein: the magnified image is obtained an inspection unit (500, 500a) including an electron microscope (510, 540) and a display unit (520), and
wherein the electron microscope (510, 540) is positioned above the notched area of the substrate sheet (100, 100a) to provide the magnified image as viewed from above.
